**Europäisches Patentamt**

**European Patent Office**

**Office européen des brevets**

(19)

(11) Publication number : **0 632 348 A1**

# (12) EUROPEAN PATENT APPLICATION

(21) Application number : **94304629.2**

(22) Date of filing : **24.06.94**

(51) Int. Cl.⁶ : **G03H 1/26, G02F 1/29, G11C 13/04, G03H 1/10, G02B 5/18**

(30) Priority : **28.06.93 US 83805**

(43) Date of publication of application :
**04.01.95 Bulletin 95/01**

(84) Designated Contracting States :
**DE FR GB**

(71) Applicant : **International Business Machines Corporation**
**Old Orchard Road**
**Armonk, N.Y. 10504 (US)**

(72) Inventor : **Sincerbox, Glenn Tavernia**
**1309 Pernich Court**
**San Jose, California 95120 (US)**

(74) Representative : **Davies, Simon Robert**
**I B M**
**UK Intellectual Property Department**
**Hursley Park**
**Winchester, Hampshire SO21 2JN (GB)**

(54) **Volume holographic storage system.**

(57) A phase encoded volume holographic storage system uses a phase encoding multiplexer 40 that generates truly binary phases of light in the reference beam. The phase encoding multiplexer comprises a liquid crystal device having an array of liquid crystal cells 71, 73 that convert the reference beam into an array of parallel beamlets 65, 67 of light. Each cell in the array has electrodes patterned as two sets of parallel fingers, with each set forming a diffraction grating 83, 85. The sets of fingers are interdigitally spaced so that fingers on the two sets are spaced apart a distance equal to one-half the grating period. Means are provided for activating only one of the diffraction gratings in each cell at any one time. Thus each beamlet of light exiting each cell when one of the diffraction grating patterns is activated is precisely 180 degrees out of phase with the light exiting the cell when the other complementary diffraction grating pattern is activated. The phase modulator is connected to a data controller that activates each electrode in each cell of the array according to predetermined orthogonal codes, thereby permitting multiple pages of data to be recorded in the holographic medium with each page being recorded according to a different one of the phase codes from the reference beam.

FIG. 1

EP 0 632 348 A1

This invention relates in general to three-dimensional or "volume" holographic storage systems, and in particular to such systems which use phase-encoded reference beams to record the superposed images or pages in the holographic recording material.

In a volume hologram, interference of radiation from an object or signal beam and a reference beam produces an interference structure of maximum and minimum field intensities that generates in the holographic medium a like structure with maximum and minimum change in some optical property, such as refractive index. If the hologram is considered thick, i.e., the thickness of the medium is much greater than the spacing of the recorded structure, diffraction from the recorded structure is highly sensitive to changes in either the angle or wavelength of illumination. A reconstructing beam that is incident on the structure created in the medium will then reconstruct an exact image of the object, provided the reconstructing beam is coincident with and of the same wavelength as the original reference beam. This requirement makes it possible to record many images or pages, superposed in the medium, by varying the angle of incidence (angular multiplexing) or the wavelength (wavelength multiplexing) of the reference beam, or both. These multiple images or pages can then be read out of the medium by a reconstructing beam directed at the same angle of incidence and with the same wavelength.

Angular multiplexing of the reference beam in volume hologram systems is accomplished with some type of beam deflection mechanism, such as a galvanometer mirror or an acousto-optic device. Galvanometers are relatively slow and require a servo control system to maintain a given access direction. Acousto-optic devices have limited angular range and must be used in both the signal and reference beams because they introduce a wavelength shift in the deflected beam. In both mechanisms any error in angular direction will cause adjacent holograms to be reconstructed along with the desired hologram, and the resulting crosstalk will reduce data reliability.

Wavelength multiplexing requires some means for control of the wavelength of the recording beams. While this can be done with tuning of certain diode lasers, these lasers operate in a region of the spectrum where there are few materials available for the holographic medium. An alternative is to use large and expensive dye lasers that are not practical for compact data storage devices.

More recently, a different multiplexing scheme for volume holographic storage systems has been proposed. In this approach, called phase encoding and described by C. Denz et al. in "Volume Hologram Multiplexing Using a Deterministic Phase Encoding Method," Optics Communications, 85 (1991), 171-176, the same set of individual reference beams that are used in angular multiplexing is used, but all of the beams are on at all times, with only the phases of the beams being varied between states of 0 and 180 degrees. Individual holograms are recorded and retrieved by a unique phase code corresponding to each hologram. This phase-encoding method has the advantages that it uses all of the beam power and does not require beam deflection. The phase modulation of each beam is achieved by a liquid crystal cell operating in the "phase only" mode below its optical threshold, where the application of a small voltage causes a 180-degree phase retardation of the beam traversing the cell.

The primary problem with phase-encoded multiplexing is that for there to be no crosstalk between adjacent holograms, the phases of the individual reference beams must be exactly 0 or 180 degrees. The liquid crystal cell used as the phase modulator is an analog device in which the phase retardation is a nonlinear function of the applied voltage. Moreover, this function will vary due to variations in such parameters as cell thickness and surface treatment during cell manufacture. Thus, a liquid crystal cell operating in the phase-only mode will require some type of feedback to servo control the applied voltage if the cell is to function as a truly binary phase modulator for the reference beams.

Thus, what is needed is an improved phase-encoded volume holographic storage system which uses a truly binary phase modulator that is independent of applied voltage and does not require complex or costly feedback control.

Accordingly, the invention provides a volume holographic storage system comprising:

a holographic medium;

a light source;

means for forming the light from the light source into a signal beam and a reference beam;

means located within the signal beam for modulating the light in the signal beam;

means located within the reference beam for modulating the phase of light in the reference beam for each modulation of light in the signal beam, the phase modulating means including means for dividing the reference beam of light into a plurality of parallel beamlets of light and means for generating binary complementary phases for each of the beamlets of light;

means for directing the modulated signal beam to the medium;

means for directing the reference beamlets of light to the medium to record a hologram in the medium by interference with the modulated signal beam; and

means optically coupled with the medium for detecting the recorded hologram.

The use of a phase modulator or multiplexer in which binary complementary phases of light are generated for each beamlet ensures proper orthogonality and lack of cross-talk between the beams, without the need for any feedback servo system or the like.

In a preferred embodiment, the means for generating complementary phases for each of the beamlets of light comprises means for generating complementary diffraction gratings, and more particularly, a plurality of light transmissive cells, each cell being optically aligned with a corresponding reference beamlet of light and having formed therein two diffraction gratings displaced from each other by one-half a grating period, each of the gratings being switchable between states of diffraction and non-diffraction; and means coupled to the two diffraction gratings for activating only one of the two diffraction gratings at any one time; whereby only one of the gratings is substantially diffracting at any one time. The cells are liquid crystal cells. Preferably each diffraction grating comprises a liquid crystal cell electrode having a pattern of parallel fingers, the two patterns forming the two diffraction gratings in each cell being arranged with their fingers interdigitally spaced by one-half the spacing of the fingers in each diffraction grating. It is further preferred that the means for activating the cells further comprises means for activating all of the cells simultaneously according to a predetermined digital code, each code corresponding to a single modulation of the signal beam, and the means for modulating the light in the signal beam comprises a spatial light modulator for modulating the light in the signal beam into a plurality of points of light representative of digital data, and the system further includes a controller coupled to the spatial light modulator and the phase modulating means for transmitting a page of digital data to the spatial light modulator and for activating one or the other of the diffraction gratings in each of the cells according to one of a plurality of predetermined codes.

The volume holographic storage system so far described is capable of both reading and writing; clearly systems may be designed with a read only capability, in which case the components associated with the signal beam are no longer required (only the reference beam is used for reading), but the same phase modulator as described above may be used. Accordingly, the invention also provides a binary phase modulator for a volume hologram system having a light source which generates a reference beam of light, the modulator comprising: a plurality of adjacent light transmissive cells for dividing the reference beam into a plurality of parallel light beamlets, each cell having formed therein two diffraction gratings spaced apart by one-half the grating period, each of the gratings being switchable between states of substantially diffracting and non-diffracting to light.

Thus a phase encoded volume holographic storage system is provided in which the phases of light used in the reference beam to provide the encoding are truly binary. Such a phase modulator comprises, in the preferred embodiment, a liquid crystal device having an array of liquid crystal cells that convert the reference beam into an array of parallel beamlets of light. Each cell in the array has electrodes patterned as two sets of equally-spaced parallel fingers, with each set forming a diffraction grating. The two sets of fingers are interdigitally positioned so that fingers on the two sets are interleaved and positioned exactly half-way between each other. The spacing of the electrode fingers in each set satisfies the Bragg condition:

$$2d\sin\Theta = \lambda ;$$

where $\Theta$ is the angle by which the beam is diffracted, $\lambda$ is the wavelength, and $d$ is the spacing between the fingers, or the period of the diffraction grating. Means are provided for activating only one of the diffraction gratings in each cell at any one time. Thus each beamlet of light exiting each cell when one of the diffraction grating patterns is activated is precisely 180 degrees out of phase with the light exiting the cell when the other complementary diffraction grating pattern is activated. The phase modulator is connected to a data controller that activates each electrode in each cell of the array according to predetermined orthogonal codes, thereby permitting multiple pages of data to be recorded in the holographic medium with each page being recorded according to a different one of the phase codes from the reference beam.

An embodiment of the invention will now be described in detail by way of example with reference to the following drawings:

Fig. 1 is a schematic block diagram illustrating the major components of a volume holographic storage system having multiplexing.

Fig. 2A is a top view of a multiplexer according to the present invention and usable with the volume holographic storage system illustrated in Fig. 1.

Fig. 2B is a side view of the multiplexer shown in Fig. 2A.

Fig. 3A is a top view of a liquid crystal phase modulator showing the eight individual liquid crystal cells.

Fig. 3B is a side sectional view showing the liquid crystal phase modulator of Fig. 3A.

Fig. 4 is a view of one cell of the liquid crystal phase modulator of Fig. 3A and illustrating the complementary pattern of electrodes with interdigital fingers.

Fig. 5 is a view of the cell of Fig. 4 with one of the electrodes activated.

Fig. 6 is a view of the cell of Fig. 4 with the complementary electrode activated.

Fig. 7 is a graphical representation of the eight orthogonal codes of a one-dimensional Walsh code.

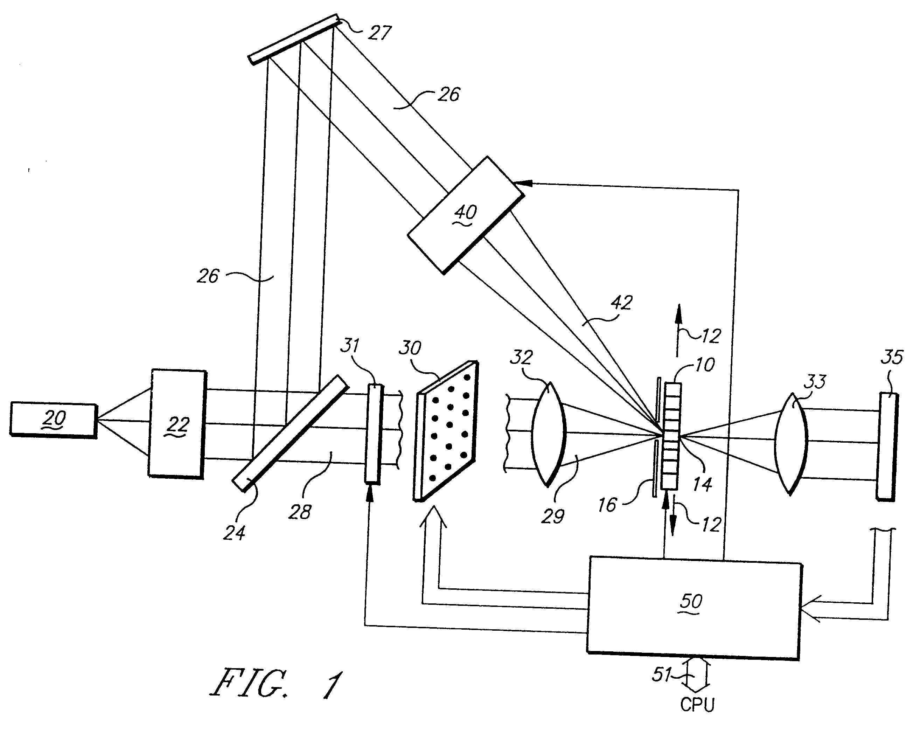

A general schematic of a volume hologram system is illustrated in Fig. 1. Essentially the same overall system is used both in the prior art and for the present invention; the difference lies in the multiplexer 40, which in the prior art is typically a conventional angular multiplexer, whereas, as explained in more detail below, according to the present invention it has a very different construction.

The holographic recording medium 10 is a thick film of any conventional holographic recording material, such as a photorefractive material or a photographic emulsion. A BaTiO$_3$ crystal is one example of a known photorefractive material. The medium 10 is movable along an axis in the directions shown by the arrows 12 so that individual discrete sections of the medium, such as section 14, may be located in front of a fixed mask 16 through which the light may enter.

A light source 20, such as a laser diode, generates a single, monochromatic, coherent light beam that is directed through a set of beam-forming optics 22. The beam-forming optics expand and collimate the output from light source 20, and if the light source 20 is a laser diode, also circularize the beam. The single-beam output from the beam-forming optics 22 is then split by a conventional beam splitter 24 into a reference beam 26 and an object or signal beam 28.

A page composer or spatial light modulator 30 and a Fourier transform lens 32 are located in the signal beam 28 between the light source 20 and the medium 10. The spatial light modulator 30 is a two-dimensional array of "shutters" which either permit or block part of the signal beam 28. A typical embodiment of a spatial light modulator is a liquid crystal device having a two-dimensional array of cells, each of which can be either transparent or opaque under the application of an appropriate voltage. Thus, for example, if the liquid crystal spatial light modulator 30 contains an array of 1000 x 1000 cells, it converts the signal beam 28 into 1,000,000 individual point sources of light, each point representing a "one" or "zero" bit, depending upon whether the associated cell is transparent or opaque in the presence of an applied voltage. While Fig. 1 is a one-dimensional schematic drawing, the spatial light modulator 30 is shown in perspective view for illustrating the individual cells in the two-dimensional array that convert the signal beam 28 into the multiple points of light. While this description of the spatial light modulator 30 is directed toward the application of volume holography to digital data storage, the spatial light modulator could also be a mechanism that places photographic transparencies or masks in the signal beam to store a plurality of nondigital images in the medium 10.

The lens 32 is located a focal distance from both the spatial light modulator 30 and the holographic medium 10 to form the Fourier transform of the light distribution impressed by spatial light modulator 30 in signal beam 28 onto the section 14 of medium 10. The lens 32 thus takes the point sources of light which come from modulator 30 as parallel beams of light, and directs them to the medium 10, each parallel beam corresponding to light transmitted through one of the cells of the two-dimensional array of the modulator 30. These individual beams become signal beam 29 and arrive at different angles at the medium from lens 32 to overlap at the section 14 of medium 10.

The reference beam 26 split by beam splitter 24 is directed by a mirror 27 through a multiplexer 40 and onto the section 14 of medium 10. Both the output reference beam 42 from multiplexer 40 and the beam 29 from lens 32 arrive simultaneously and interfere with one another in the section 14 of recording medium 10.

A shutter 31 is located in the path of the signal beam 28 between beam splitter 24 and spatial light modulator 30 for blocking the signal beam during reconstruction of the recorded hologram. An inverse Fourier transform lens 33 is located on the side opposite the recording medium 10 from the lens 32. Lens 33 is spaced a focal distance from medium 10 and from a data detector array 35. The data recorded in the section 14 of the medium 10 is reconstructed or read out in the conventional manner by movement of shutter 31 into the signal beam so that only the reference beam 42 is directed to section 14 of the medium 10. This generates the transform image of the recorded hologram that is directed to the detector array 35. The detector array 35 has the same two-dimensional array pattern as the spatial light modulator 30 so that its output corresponds to the data input to modulator 30.

The operation of the volume holographic system shown in Fig. 1 as a digital data storage system will be explained with reference to the operation of data controller 50. Controller 50 receives data from a data bus 51 connected to the host central processing unit (CPU) and transmits that data as a page of digital data to spatial light modulator 30. The controller 50 also receives data output from data detector array 35 and directs it back to the CPU via data bus 51. The data controller 50 is also electrically connected to shutter 31, multiplexer 40, and the movable medium 10. To record a first page of data into section 14 of the recording medium 10, the data controller 50 moves shutter 31 out of the path of signal beam 28, translates medium 10 so that section 14 is in alignment with the opening of mask 16, and signals multiplexer 40. If multiplexer 40 is an angular multiplexing device, it is moved to its first angular position. The data making up the first page is then recorded in section 14 of medium 10 by the interference of reference beam 42 with the signal beam 29 that has passed through the spatial light modulator 30 whose array has received the page of data from controller 50. To record the next page in the same section 14 of medium 10, controller 50 signals multiplexer 40 to move to its next angular position and the second page is recorded in the same section 14. Depending upon the number of angular positions achievable by multiplexer 40, a plurality of pages are thus recorded in the same section 14 of medium 10. When the maximum number of pages is recorded in section 14, controller 50 then moves medium 10 until the next adjacent section, or any section, is aligned with the opening in mask 16. In this manner, multiple pages can be multiplexed onto individual sections of the medium 10 and multiple sections can be addressed by controller 50. When it is desired to read out data recorded in the medium 10, the controller 50 moves shutter 31 into the signal beam 28 to block the signal beam 28 so that only the reference beam 26 is on, and signals multiplexer 40 to the correct angular position. This reference beam then becomes a reconstructing beam (with the same wavelength and angle as the reference beam) which is directed to the appropriate section of the medium 10 and reconstructs the recorded image through inverse transform lens 33 onto detector array 35.

The conventional means for providing the multiplexing, as shown schematically by block 40 in Fig. 1, is a device to provide angular movement of the reference beam 26 to generate a beam 42 through a plurality of minute angles. Alternatively, multiplexing can be achieved by changing the wavelength of the laser source 20 and recording and retrieving individual pages of information at each wavelength. Both approaches take advantage of the Bragg effect and thus enable the recording of multiple pages of data into the same section of the recording medium.

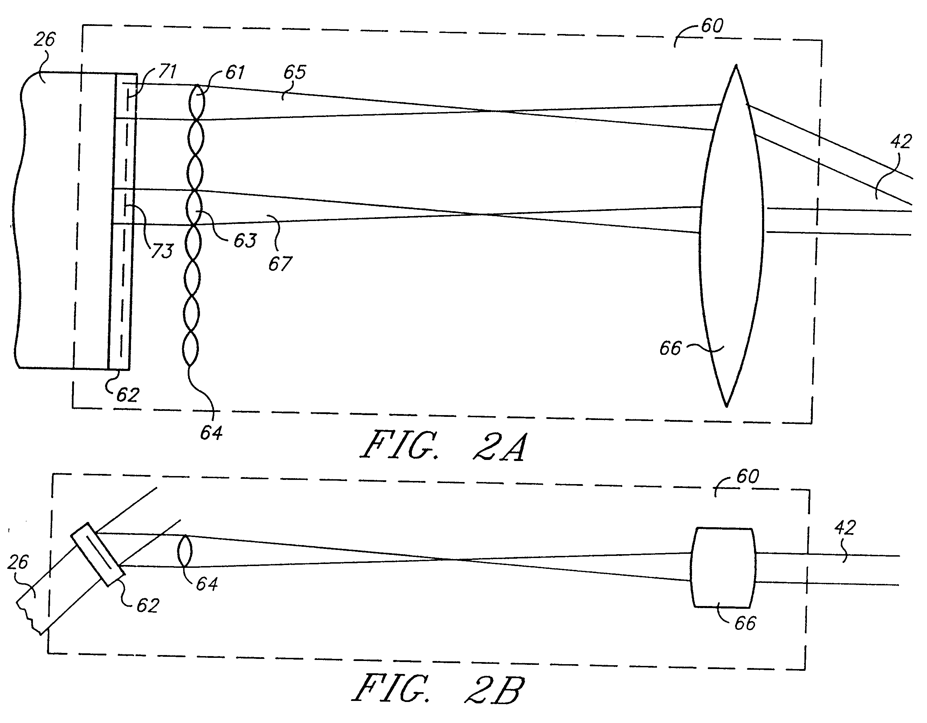

The present invention is a volume holographic storage system as described in Fig. 1, but in which the multiplexer is an improved phase-encoding multiplexer. This multiplexer is shown as a one-dimensional multiplexer 60 in the top view of Fig. 2A and in the side view of Fig. 2B. As illustrated, the reference beam 26 enters the multiplexer 60 and exits as output reference beam 42. The multiplexer 60 comprises a binary phase modulator 62, a lens array 64, and a focusing lens 66. Lens array 64, as shown in Fig. 2A, comprises a series of individual adjacent lenses, such as typical lenses 61, 63, which convert the reference beam 26 into an array of parallel beamlets, such as typical beamlets 65, 67. The array of individual beamlets is then converted by lens 66 into overlapping beamlets focused as output reference beam 42 onto the section 14 of holographic medium 10 to provide the interference with the signal beam 29 from lens 32 (Fig. 1). For clarity, only two beamlets are shown in Fig. 2A as making up output reference beam 42, but all beamlets from each of the individual lenses in array 64 are present in output beam 42.

The binary phase modulator 62 contains a plurality of cells, each cell corresponding to an associated lens in the lens array 64, and provides two binary states of the incoming light beam 26 into phases of either 0 or 180 degrees. For example, cells 71, 73 are aligned with and correspond to lenses 61, 63, respectively. Thus, in contrast to conventional angular multiplexing or wavelength multiplexing, the phase-encoded multiplexer 60 does not mechanically move the output reference beam 42 to different positions on medium 10 or change the wavelength of the incident radiation, Instead, multiplexer 60 generates a fixed beam 42 made up of overlapping beamlets, each of which is in an appropriate binary phase of either 0 or 180 degrees, depending on the state of the individual cell from which the beamlet originates.

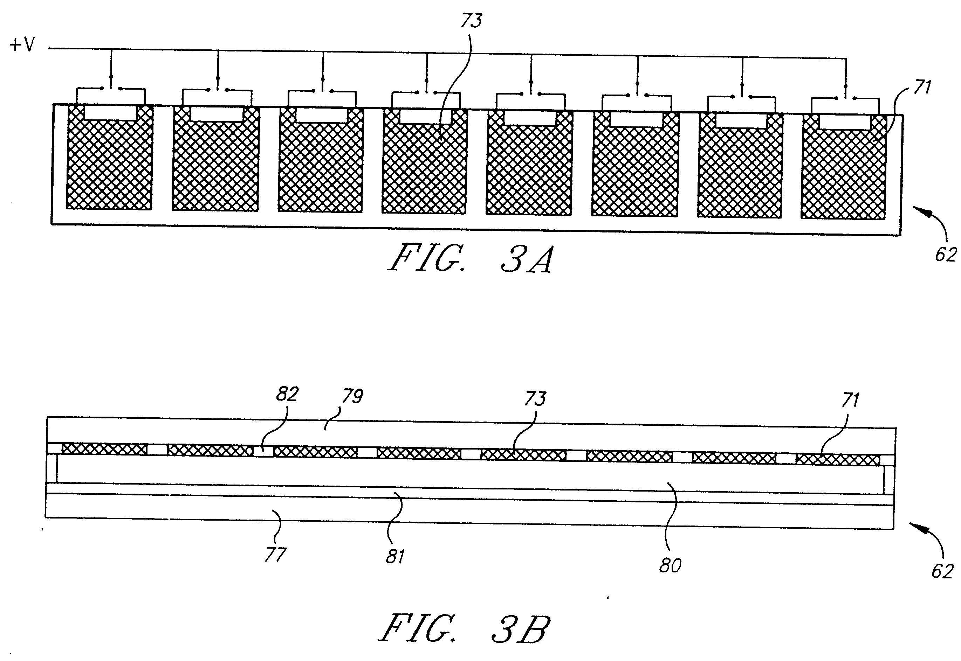

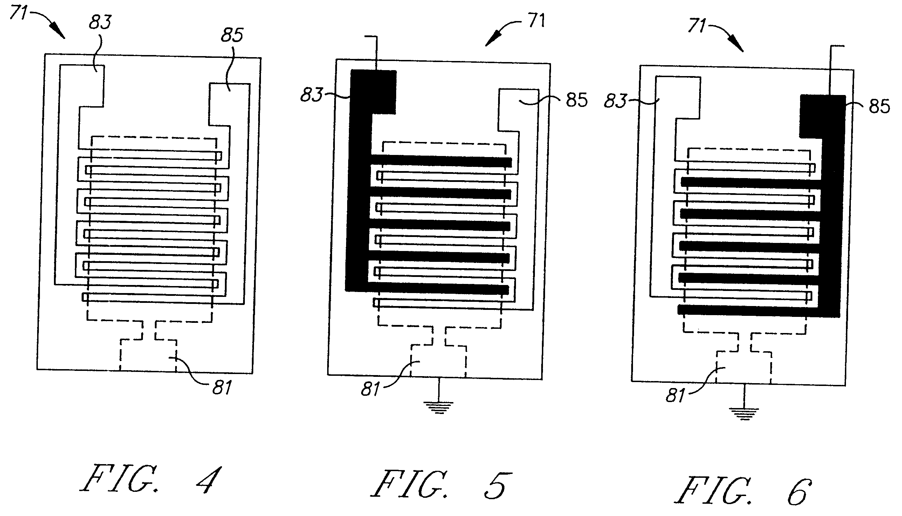

In the preferred embodiment, the binary phase modulator 62 is a liquid crystal device, as shown in Figs. 3A and 3B, where it is depicted as a one-dimensional array containing eight individual cells, each cell corresponding to an associated lens of the aligned lens array 64. For example, cell 71 corresponds to lens 61 and cell 73 corresponds to lens 63. As shown in the side view (Fig. 3B) of the liquid crystal binary phase modulator 62, the liquid crystal material 80 is located between a lower electrode 81 formed on lower glass plate 77 and an upper electrode 82 formed on upper glass plate 79. The application of voltage to the appropriate cell activates that cell to an appropriate phase in the manner described below with reference to Figs. 4-6.

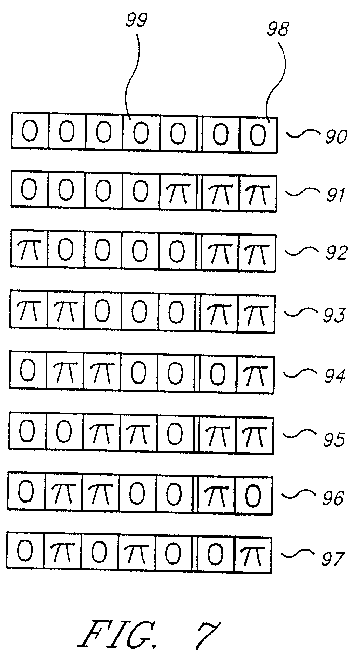

A typical cell 71 is shown in Fig. 4. The lower electrode 81 is shown by the dotted line and its generally rectangular outline is the cell window through which the light from input reference beam 26 (Fig. 2A) passes toward corresponding lens 61 to generate the beamlet 65 in output reference beam 42. The portion of the upper electrode 82 of the liquid crystal device (Fig. 3B) making up cell 71 includes two separate patterns forming two distinct electrodes 83, 85. As shown in Fig. 5, when a voltage is applied to electrode 83, by means of any conventional switching circuitry, the pattern of parallel fingers making up electrode 83 applies a periodic electric field to the liquid crystal material 80 between electrode 83 and electrode 81, so that the optical properties or light transmissive properties of the material become altered in the region defined by the pattern. This creates a diffraction grating defined by the spacing of the parallel fingers or lines. Beam 26 passing through this grating is diffracted into angle $\Theta$, where $\Theta$ is given by $2d\sin\Theta = \lambda$, and $d$ is the period or spacing of the induced grating lines (equal to the spacing of the electrode fingers). Similarly, as shown in Fig. 6, when a voltage is applied to electrode 85 a complementary pattern of parallel fingers or lines creates a second diffraction grating of the same spacing but displaced by a distance $d/2$ from the first grating. The beamlet 65 (Fig. 2A) diffracted by the grating of electrode 83 and a complementary beamlet diffracted by the grating of electrode 85 are identical, with the exception that they are shifted in phase by exactly 180 degrees. This is because the interdigital lines of the two electrodes are lithographically formed on the cell 71 to be spaced apart precisely one-half the spacing of the lines in each of the complementary sets, i.e., $d/2$. This takes advantage of the fact that diffraction patterns from complementary diffracting structures are identical except for a 180-degree shift in phase. The term "complementary" refers to the fact that there is an exchange of regions of the cell that are either transparent and opaque or of high refractive index and low refractive index. Thus, in the present invention, the two liquid crystal gratings defined by electrodes 83 and 85 are complementary, and the cell generates a truly binary phase encoding, i.e., the light exiting the cell when one electrode is activated is precisely 180 degrees shifted in phase from light exiting when the other electrode is activated.

In the preferred embodiment, the liquid crystal material 80 (Fig 3B) is a nematic liquid crystal, such as that used in hand-held televisions, and is contained between the two glass plates 77, 79 onto which the transparent electrode structures 81, 82 are formed. The electrodes may be deposited films of indium tin oxide. The nominal total cell thickness is approximately 5-25 microns. To provide alignment of the liquid crystal molecules on the inside of the cell, the inside surface of each glass plate 77, 79 is prepared before assembly by rubbing in a single direction or by the oblique deposition of a layer of magnesium fluoride. The fabrication of the electrode patterns with the spaced interdigital fingers is by means of conventional lithography. The individual grating lines in each electrode 83, 85 (Fig. 4) have a width of 5-10 microns and are spaced apart approximately 20-40 microns, with the interdigital fingers being separated by exactly one-half the spacing of the fingers on an individual set. The plates are assembled into the cell with the rubbing directions aligned. This is in contrast to conventional display panels, such as those used in hand-held televisions, where the rubbing directions on the two plates are oriented at 90 degrees to each other. In the binary phase-only liquid crystal modulator assembled with the rubbing directions aligned, the application of voltage does not affect the polarization of light passing through the cell, but only the refractive index.

The advantage of the present invention over the prior art techniques of phase encoding in volume holographic storage is that the direction and phase of the individual beamlets from the multiplexer are independent of the applied voltage and cell inhomogeneities.

While the phase-encoded multiplexer 60 (Figs. 2A-2B) has been illustrated by use of the preferred embodiment of a liquid crystal device as a binary phase modulator, any material that undergoes a change in its optical or mechanical properties with applied voltage may be used to form the periodic grating, and thus function as the binary phase modulator 62. As one alternative embodiment, the modulator 62 can be a ferroelectric liquid crystal device. By an appropriate surface stabilization pretreatment of the cell, the ferroelectric material can exhibit bistability in its molecular orientation. A typical ferroelectric liquid crystal material is Merck ZLI-4003. The ferroelectric liquid crystal cell can be operated as a phase pattern for increased light throughput by rotating the cell so that the angle between the downstate optical axis and the incident polarization direction is approximately 25 degrees, as described by S. Fukushima et al., "Realtime Hologram Construction and Reconstruction Using a High Resolution Spatial Light Modulator," Appl. Phys. Lett., 58, 787 (1991).

Referring now to Fig. 7, there is illustrated a table showing examples of eight orthogonal codes of eight bits each. Fig. 7 represents a one-dimensional Walsh code which the one-dimensional binary phase modulator 62 would output. As shown in the top row 90 of Fig. 7, all of the phases of the eight individual beamlets from lens array 64 (Fig. 2A) are represented as zero. The blocks 98, 99 in row 90 represent the binary output, in this case zero, from beamlets 65, 67 generated by passage through corresponding cells 71, 73. The code in row 90 would be generated, for example, by having all of the same electrodes 83 activated for all of the cells. Beneath row 90 in Fig. 7 are the seven other possible codes 91-97, each code corresponding to an appropriate selection of 0 or 180 as the phase generated by each of the individual cells in the binary phase modulator 62.

The operation of the volume holographic storage system using the binary phase modulation encoding system of the present invention can be understood by referring again to Fig. 1. When the controller 50 sends data, corresponding to a first page of digital data, to spatial light modulator 30, it signals the binary phase modulator 62 (Fig. 2A) of multiplexer 60 to generate one of the eight Walsh codes shown in Fig. 7. The result is that the first page is recorded in section 14 of medium 10 due to the interference of the signal beam 29 with the output reference beam 42 formed of the individual overlapping beamlets, each beamlet having an appropriate phase according to the generated Walsh code. When a second page is to be recorded in the same section 14 of medium 10, controller 50 signals multiplexer 62 to create a second orthogonal Walsh code, one of the codes of Fig. 7 being selected. The result is that, in the example given, up to eight individual pages can be recorded in the same section 14 of medium 10. To read out an appropriate one of these eight recorded pages, controller 50 moves shutter 31 to block the signal beam 29 and signals multiplexer 62 to apply the appropriate voltages to each cell in binary phase modulator 62 to reproduce the Walsh code corresponding to the desired page to be read out of medium 10. The reference beam 42 comprising the overlapping phase-encoded beamlets then acts as the reconstructing beam, which enables the appropriate page of data to be detected by detector array 35 and transmitted through controller 50 back to the CPU.

For simplicity the multiplexer 60 has been described as a one-dimensional system that comprises eight individual liquid crystal cells and their corresponding lenses in the lens array 64. However, the invention can operate with two-dimensional liquid crystal arrays and corresponding lens arrays, in which case a well-known two-dimensional Walsh code would be used to generate the phase encoding.

**Claims**

1. A volume holographic storage system comprising:

  a holographic medium (10);

  a light source (20);

  means (24) for forming the light from the light source into a signal beam (28) and a reference beam (26);

  means (30) located within the signal beam for modulating the light in the signal beam;

  means (40) located within the reference beam for modulating the phase of light in the reference beam for each modulation of light in the signal beam, the phase modulating means including means (62, 63) for dividing the reference beam of light into a plurality of parallel beamlets of light (65, 67) and means (83, 85) for generating binary complementary phases for each of the beamlets of light;

  means (32) for directing the modulated signal beam to the medium;

  means (66) for directing the reference beamlets of light to the medium to record a hologram in the medium by interference with the modulated signal beam; and

  means (35) optically coupled with the medium for detecting the recorded hologram.

2. The system according to claim 1 wherein the means for generating complementary phases for each of the beamlets of light comprises means for generating complementary diffraction gratings.

3. The system according to claim 2 wherein the phase generating means further comprises:

  a plurality of light transmissive cells (71, 73), each cell being optically aligned with a corresponding reference beamlet of light and having formed therein two diffraction gratings displaced from each other by one-half a grating period, each of the gratings being switchable between states of diffraction and non-diffraction; and

  means coupled to the two diffraction gratings for activating only one of the two diffraction gratings at any one time; whereby only one of the gratings is substantially diffracting at any one time.

4. The system according to claim 3 wherein the cells are liquid crystal cells.

5. The system according to claim 4 wherein each diffraction grating comprises a liquid crystal cell electrode having a pattern of parallel fingers, the two patterns forming the two diffraction gratings in each cell being arranged with their fingers interdigitally spaced by one-half the spacing of the fingers in each diffraction grating.

6. The system according to any of claims 3 to 5 wherein the beamlet generating means is a lens array, each lens of the array being aligned with a corresponding cell.

7. The system according to any of claims 3 to 6, wherein the means for activating the cells further comprises means for activating all of the cells simultaneously according to a predetermined digital code, each code corresponding to a single modulation of the signal beam.

8. The system according to claim 7, wherein the means for modulating the light in the signal beam comprises a spatial light modulator for modulating the light in the signal beam into a plurality of points of light representative of digital data, and further including a controller coupled to the spatial light modulator and the phase modulating means for transmitting a page of digital data to the spatial light modulator and for activating one or the other of the diffraction gratings in each of the cells according to one of a plurality of predetermined codes.

9. A binary phase modulator (40) for a volume hologram system having a light source (20) which generates a reference beam of light, the modulator comprising:

  a plurality of adjacent light transmissive cells (71, 73) for dividing the reference beam (26) into a plurality of parallel light beamlets (65, 67), each cell having formed therein two diffraction gratings (83, 85) spaced apart by one-half the grating period, each of the gratings being switchable between states of substantially diffracting and non-diffracting to light.

*FIG. 1*

FIG. 2A

FIG. 2B

EP 0 632 348 A1

+V

73

71

62

## FIG. 3A

82    79                73                                    71

77        81                                  80                        62

## FIG. 3B

EP 0 632 348 A1

FIG. 4

FIG. 5

FIG. 6

FIG. 7

**European Patent Office**

**EUROPEAN SEARCH REPORT**

Application Number

EP 94 30 4629

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | OPTICS LETTERS, vol.17, no.20, 15 October 1992, WASHINGTON US pages 1468 - 1470 HIRONORI SASAKI ET AL. 'FAST UPDATE OF DYNAMIC PHOTOREFRACTIVE OPTICAL MEMORY' * figure 3 * | 1 | G03H1/26 G02F1/29 G11C13/04 G03H1/10 G02B5/18 |
| D,X | OPTICS COMMUNICATIONS, vol.85, 1991, AMSTERDAM NL pages 171 - 176 C. DENZ ET AL. 'VOLUME HOLOGRAM MULTIPLEXING USING A DETERMINISTIC PHASE ENCODING METHOD' * figure 1 * | I | |
| X | US-A-4 120 569 (RICHARDS) * figures 2,6,9A-10B * | 1 | |
| X | US-A-3 612 641 (INTERNATIONAL STANDARD ELECTRIC CORPORATION) * figures 4,5 * | 1 | TECHNICAL FIELDS SEARCHED (Int.Cl.5) |
| A | OPTICS LETTERS, vol.18, no.11, 1 June 1993, WASHINGTON US pages 843 - 845 SHAOMIN ZHOU ET AL. 'DYNAMIC TWO-DIMENSIONAL BEAM-PATTERN STEERING TECHNIQUE' * page 843, left column; figure 1 * * page 844, right column * | 2 | G03H G02F |
| A | ELECTRONICS LETTERS, vol.9, no.8/9, 3 May 1973, ENAGE GB pages 169 - 170 S. WRIGHT ET AL. 'NEW FORM OF ELECTRO-OPTIC DEFLECTOR' | | |

The present search report has been drawn up for all claims

| Place of search | Date of completion of the search | Examiner |
|---|---|---|
| THE HAGUE | 19 September 1994 | Kleikamp, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)